(19) Europäisches Patentamt
European Patent Office
Office européen des brevets

(11) **EP 4 465 803 B1**

(12) **EUROPEAN PATENT SPECIFICATION**

(45) Date of publication and mention
of the grant of the patent:
**15.07.2026 Bulletin 2026/29**

(21) Application number: **23173886.5**

(22) Date of filing: **17.05.2023**

(51) International Patent Classification (IPC):
*H10N 50/00* (2023.01)  *H10N 50/01* (2023.01)
*H10N 50/80* (2023.01)  *H01F 1/00* (2006.01)

(52) Cooperative Patent Classification (CPC):
**H10N 50/00; H01F 1/0072; H10N 50/01;
H10N 50/80**

(54) **METHOD FOR MANIPULATING DOMAIN WALLS AND MAGNETIC RIBBON**

VERFAHREN ZUR MANIPULATION VON DOMÄNENWÄNDEN UND MAGNETBAND

PROCÉDÉ DE MANIPULATION DE PAROIS DE DOMAINE ET RUBAN MAGNÉTIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**20.11.2024 Bulletin 2024/47**

(73) Proprietor: **Max-Planck-Gesellschaft zur
Förderung der
Wissenschaften e.V.
80539 München (DE)**

(72) Inventors:
• **PARKIN, S.P., Stuart
06118 Halle (DE)**
• **FARINHA, André
37077 Göttingen (DE)**

(74) Representative: **Schweitzer, Klaus
Dr. Müller Patentanwälte
Mühlstraße 9A
65597 Hünfelden (DE)**

(56) References cited:
• GU K ET AL: "Three-dimensional racetrack memory devices designed from freestanding magnetic heterostructures", NATURE NANOTECHNOLOGY, vol. 17, no. 10, 22 September 2022 (2022-09-22), London, pages 1065 - 1071, XP093095384, ISSN: 1748-3387, Retrieved from the Internet <URL:https://www.nature.com/articles/s41565-022-01213-1.pdf> DOI: 10.1038/s41565-022-01213-1

• ZHUKOV A P: "The remagnetization process of bistable amorphous alloys", MATERIALS AND DESIGN, LONDON, GB, vol. 14, no. 5, 1 January 1993 (1993-01-01), pages 299 - 306, XP022782500, ISSN: 0261-3069, [retrieved on 19930101], DOI: 10.1016/0261-3069(93)90130-N

• KAMER O ET AL: "Direct current hysteresis loops of Fe-based amorphous ribbons under stress and torsion", JOURNAL OF PHYSICS D: APPLIED PHYSICS, vol. 32, no. 24, 21 September 1999 (1999-09-21), Bristol, GB, pages 3151 - 3156, XP093095400, ISSN: 0022-3727, Retrieved from the Internet <URL:https://iopscience.iop.org/article/10.1088/0022-3727/32/24/310/pdf> DOI: 10.1088/0022-3727/32/24/310

• PYLYPOVSKYI O V ET AL: "Coupling of Chiralities in Spin and Physical Spaces: The M�bius Ring as a Case Study", PHYSICAL REVIEW LETTERS, vol. 114, no. 19, 15 May 2015 (2015-05-15), US, XP093095393, ISSN: 0031-9007, DOI: 10.1103/PhysRevLett.114.197204

• CORODEANU S ET AL: "Field and Current Controlled Domain Wall Propagation in Twisted Glass-Coated Magnetic Microwires", SCIENTIFIC REPORTS, vol. 9, no. 1, 10 April 2019 (2019-04-10), pages 1 - 8, XP093094012, Retrieved from the Internet <URL:https://www.nature.com/articles/s41598-019-42352-1.pdf> DOI: 10.1038/s41598-019-42352-1

**EP 4 465 803 B1**

## Description

The present disclosure relates to a method for changing the magnetic properties of Domain Walls (DWs) moving over/along racetrack ribbons. Particularly, the magnetic properties include dynamic magnetic properties such as driving torque, DW velocity, threshold current, DW tilting, etc.

Over the past decades, computers have become indispensable in our daily lives. In conventional computers, computation and data storage are physically separated, which is commonly referred to as a von Neumann architecture. However, von Neumann computers will ultimately fail to meet the increasing demand for the emerging applications such as the internet of things (IoT), which require ultra-low power consumption, a compact architecture, as well as big data, which requires frequent access to vast amounts of data.

In order to meet these requirements, scientists are looking beyond conventional electronic circuits and transistors, which are based on the control of the electron charge, and have turned instead to its spin. The electron spin, due to its quantum properties, can only point up or point down. This is an ideal property for digital data where spin up and spin down can represent 1's and 0's. Indeed, magnets, the collective manifestation of the electron spin, have been used as storage bits in magnetic hard disc drives (HDDs) since the 1950s. Despite the extensive industrial use of magnets for data storage, one of the key challenges is to build a microprocessor using spinbased logic devices. Such devices would combine the best of two worlds, namely the data processing capability of transistors with the non-volatile memory of magnets, thus eliminating the need for energy-hungry data refresh processes. In the early 2000's the idea of magnetic domain wall (DW) logic was proposed with logic operations performed by driving domain walls with a magnetic field through nanoscale wires/ribbons in a tailor-made device. Magnetic domain walls are small regions separating magnetic domains with different magnetization. In 2004, scientists from IBM developed the concept of racetrack memory where the magnetic domain walls are shifted along a nanowire/ribbon using an electric current, making a high-density, high-speed, and non-volatile data storage device possible (e.g. US 6,834,005). Nevertheless, the realization of controlled manipulation of magnetic domain walls, which would e.g. allow for the manufacture of logic devices, remained to be achieved.

Recently, an all-electric logic device based on magnetic domain walls in racetracks was created using a type of magnetic coupling, called "lateral chiral coupling". Here, adjacent magnetic domains with out-of-plane and in-plane magnetizations are coupled with a fixed chirality via the interfacial Dzyaloshinskii-Moriya interaction (DMI), which was proposed by the scientists Dzyaloshinskii and Moriya 60 years ago. Exploiting this chiral coupling, a magnetic domain wall inverter was created (Luo, Z., Hrabec, A., Dao, T.P. et al. Current-driven magnetic domain-wall logic. Nature 579, 214-218 (2020)). When passing through the inverter, an up|down domain wall transforms into a down|up DW and vice versa. This inverter is equivalent to a NOT gate in the Boolean logic with the binary data encoded into the magnetization of the moving domains, i.e. down ="1" and up ="0". Using a similar principle, a NAND gate was realized, which is a universal gate, so that any other logic operation can be achieved with a combination of several NAND gates.

In such an inverter, the function of the device is the same for both types of DW. However, other advanced functions would require DW-sensitive action, i.e. that the device affects updown and downup DWs differently. Only such individual DW manipulation would enable the precise control of DW flow through a device, providing e.g. for the implementation of neuromorphic devices, or DW logic, such as a DW diode, a DW filter, a DW multiplexer, a device that tunes the shift between two DWs, or a device that selectively nucleates DWs of a specific type by current. Other examples of prior art are GU K ET AL: "Three-dimensional racetrack memory devices designed from freestanding magnetic heterostructures", NATURE NANOTECHNOLOGY, vol. 17, no. 10, pages 1065-1071, 22 September 2022; ZHUKOV A P: "The remagnetization process of bistable amorphous alloys", MATERIALS AND DESIGN, vol. 14, no. 5, pages 299-306, 1 January 1993; KAMER O ET AL: "Direct current hysteresis loops of Fe-based amorphous ribbons under stress and torsion", JOURNAL OF PHYSICS D: APPLIED PHYSICS, vol. 32, no. 24, pages 3151-3156, 21 September 1999; PYLYPOVSKYI O V ET AL: "Coupling of Chiralities in Spin and Physical Spaces: The Möbius Ring as a Case Study", PHYSICAL REVIEW LETTERS, vol. 114, no. 19, 197204, 15 May 2015; CORODEANU S ET AL: "Field and Current Controlled Domain Wall Propagation in Twisted Glass-Coated Magnetic Microwires", SCIENTIFIC REPORTS, vol. 9, 5868, 10 April 2019.

## Problem

In standard electronic devices, the ability to change the magnetic properties within a given device is mostly limited to the ability to pattern different high-quality materials and material stacks in different regions of the device. This implies a difficult and timeconsuming optimization process of the deposition conditions and material stacks. It would, thus, be desirable to utilize intrinsically 3D geometrical effects in electronic devices to realize functionalities such as logical operations in ways that go beyond the possibilities of the above conventional 2D systems. Thus, computations and other advanced actions could be performed within the same framework as the racetrack memory, which is a central aspect of beyond Von-Neumann architectures that are so desirable in AI and state-of-the-art computation systems.

### Solution

The Inventors now have found that one can use 3D geometry driven effects in magnetic racetrack ribbons to implement abstract operations that are fundamental for digital computation and that could not be extrapolated from 2D systems. The geometry of the device itself can be used to modify the magnetic properties of the materials in different regions of a device. Since the geometrical parameter space is much larger for 3D geometries than for 2 or 2.5D geometries, as is achieved through standard fabrication methods, there are clear benefits in pursuing methodologies to prepare magnetoelectronic devices with general 3D geometries. The invention provides the ability to change the magnetic properties of the DW moving over/along a 3D ribbon, and particularly to change the dynamic magnetic properties such as driving torque, DW velocity, threshold current, DW tilting, etc. This has been achieved by imposing a curvilinear 3D structure upon at least one region of the ribbon. The curvilinear features in the 3D geometry of the ribbon of the present invention interact with the magnetic moments and their ordering in the system, leading to emergent phenomena. The control over the DW driving mechanism enables the precise control of the DW flow through a device, providing for the implementation of devices such as: neuromorphic devices, a DW diode, a DW filter, a DW multiplexer, a device that tunes the shift between two DWs, a device that selectively nucleates DWs of a specific type by current, or the precise stepwise motion of DWs.

### Brief Description of the Invention

The present invention, therefore, relates to a method for manipulating domain walls (DWs) in a magnetic ribbon, as defined by appended claim 1.

Moreover, the present invention relates to a curvilinear 3D magnetic ribbon, as defined by appended claim 7. Preferably, the curvilinear 3D magnetic ribbon is a ribbon, which extends between two ends and which has at least one curvilinear, i.e. twisted region between its two ends wherein the twisted region exhibits an absolute torsion angle over the length of the twisted region of 1-70°, and the torsion angle has an increase per unit length of 0.5-60°.

The at least one curvilinear magnetic ribbon according to the present invention has

- a length of 5nm-1000$\mu$m, preferably 10nm-500$\mu$m, more preferred 20nm-50$\mu$m,
- a width of 5nm-20$\mu$m, preferably 5nm-10$\mu$m, more preferred 5nm-5$\mu$m,
- a thickness of 0.1-20nm, preferably 0.1-10nm, more preferred 0.5-5nm, and
- an absolute torsion angle over the total length of 1-70°, more preferred 10-45°, and preferably
- an angle increase per unit length of 0.5-45°/unit length, more preferred 1-20°/unit length.

### Brief Description of the Figures

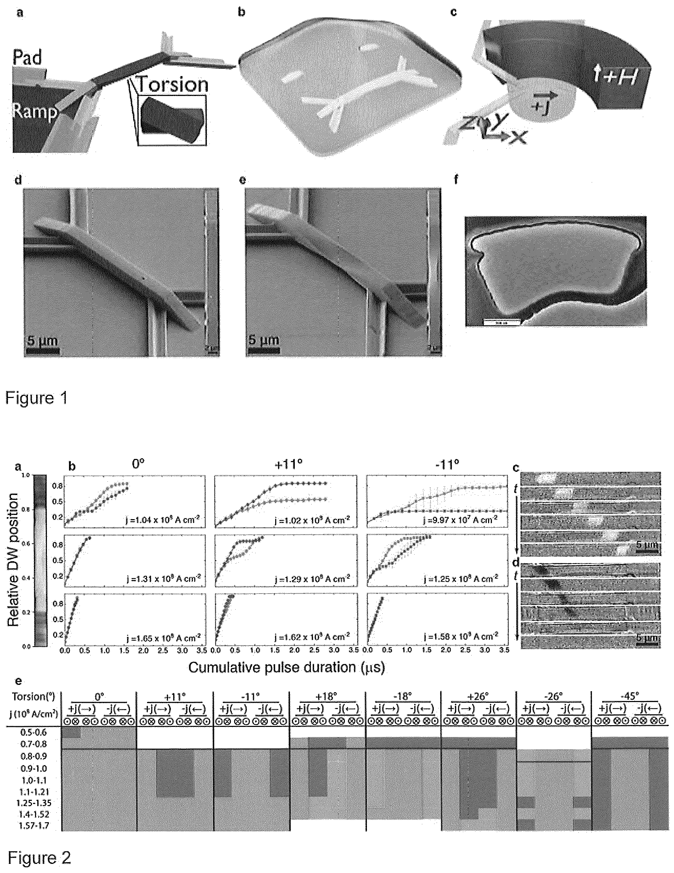

Figure 1 shows the Fabrication of the 3D magnetic twisted ribbons and images

a Functional components of the 3D device design.

b Schematics of the 3D multi-photon fabrication lithography process. The structure on the lower right corresponds to the completed one while the upper left one is under construction via laser scanning exposure.

c Schematic of the magneto-optic Kerr effect microscope setup for the current-induced DW motion measurement. An out-of-plane magnetic field (+H in "z-direction) is used to nucleate a DW.

d,e SEM perspective and top-view of devices with 0° (d) and 45° (e) torsion angles.

f TEM image of an -11° torsion device cross-section. The magnetic film stacks correspond to the black area on top of the polymer structure. Note that no film is grown on the back side of the structure.

Figure 2 shows the Torsion effect on the DW motion over the 3D devices.

a Top-view of a device with a scale of the relative position over the device length. The torsion or suspended section spans from position 0.2 to position 0.8, approximately.

b Relative DW position, as defined in (a), as a function of the cumulative pulse duration for both DW types moving along +X over 0°, +11° and -11° torsion devices. Red[-] (blue[-]) represent $\odot\otimes$ ($\otimes\odot$) DWs, respectively, and circle, diamond and square markers represent 0°, +11° and -11° torsion devices, respectively, as indicated. Each point corresponds to the averaged position from 3 measurement cycles and the error bars represent the spread in the measurements.

c,d Unprocessed Kerr images of $\odot\otimes$ (c) and $\otimes\odot$ (d). DWs driven across a +11° torsion device by a sequence of current pulses with the same properties, e.g. pulse length and number of pulses, corresponding to the +11° torsion device with $J = 1.02\times10^8$ A cm$^{-2}$ case in b. The $\otimes\odot$ DW becomes stuck in the middle of the twisted ribbon (d) while the $\odot\otimes$ passes through the whole ribbon (c).

e Qualitative summary of the acquired dataset. Green (red) correspond to the case in which the DW is able (unable) to move through the whole ribbon smoothly while orange corresponds DWs that cannot move through the whole ribbon due to fabrication defects that lower the current density for DW nucleation or splitting.

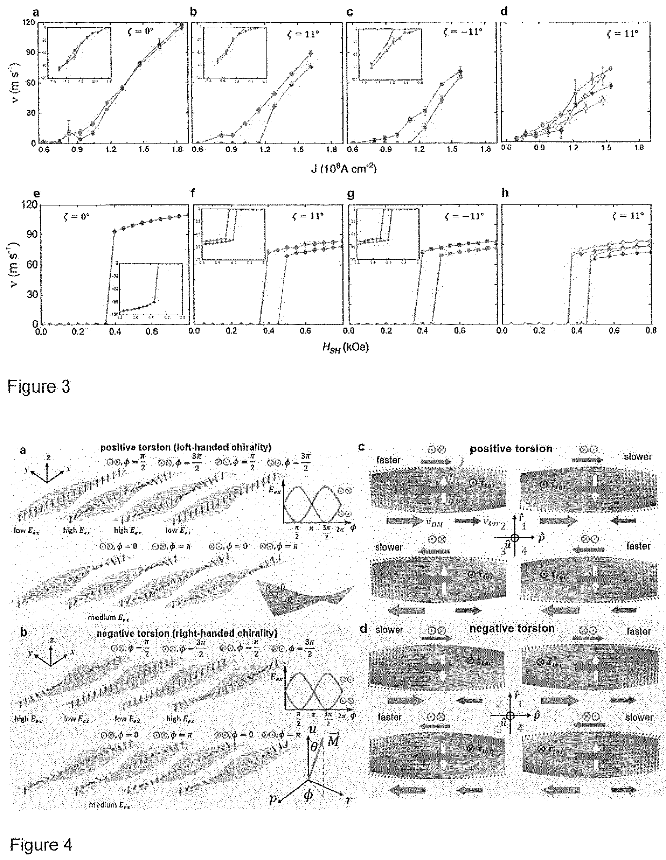

Figure 3 shows the Influence of torsion on the DW velocity in the magnetic ribbons. Red (blue) represent $\odot\otimes$ ($\otimes\odot$) DW configurations. Circle, diamond and square symbols correspond to 0 , +11° and -11° , respectively. Solid (open) symbols correspond to $J > 0$ ($J < 0$)

a-d Experimental data. Each point is the average of 2-3 measurement cycles while the error bars correspond to the standard deviation. The current-induced domain wall motion (CIDWM) for the left half of each device only are shown.
a-c v for both DW configurations for $J > 0$ for $\zeta = 0$ (a), +11° (b) and -11° (c). Insets plot v - J for $J < 0$.
d, v - J plots for $J > 0$ and $\zeta = 11°$ with w =1.25 (solid) and 5 $\mu$m (open), respectively.
e-h Corresponding model calculation for the experimental counterparts of a-d, respectively. The parameters used in the calculations are $\Delta = 5$ (e) and 3 nm (f-h), $\alpha = 0.1$, $H_k = 159.16$ kA/m (2 kOe), $H_{DM} = -79.58$ kA/m (-1 kOe) for $\odot\otimes$ and 79.58 kA/m (1 kOe) for $\otimes\odot$, $M_s = 200$ kA/m (emu cm$^{-3}$), $b = 1$ $\mu$m, $A_{ex} = 5.2 \times 10^{-11}$ J/ m (5.2 · 10$^{-6}$ erg cm$^{-1}$), $V = 2 \times 10^4$ J/m$^3$ (2 · 10$^5$ erg cm$^{-3}$) $q_0 = 4$ (e) and 2 nm (f-h), and $q_{shift} = 10$ nm.

Figure 4 shows the Mechanism of torsion dependent CIDWM in twisted magnetic ribbons.

a,b $E_{ex}$ as a function of $\phi = 0$, $\pi$ (Néel-type DW, lower cartoons) and $\frac{\pi}{2}, \frac{3\pi}{2}$ (Bloch-type DW, upper cartoons) for two DW configurations with the positive (a) and negative (b) $\zeta$ in the twisted magnetic ribbon. The arrows correspond to the local DW magnetization. Note here that the DW width equals the torsion length to illustrate how $E_{ex}$ depends on $\phi$ and $\zeta$. ($\hat{x}, \hat{y}, \hat{z}$) and ($\hat{p}, \hat{r}, \hat{u}$) are the unit vectors of the static frame and the frame fixed on the ribbon surface, respectively. $\theta$ and $\phi$ correspond to the polar and azimuthal angles of the DW magnetization, respectively in the ($\hat{p}, \hat{r}, \hat{u}$) frame.
c,d Illustration of various chiralities and torques that are associated with CIDWM in the twisted magnetic ribbons for two DW configurations with positive (c) and negative $\zeta$ (d).

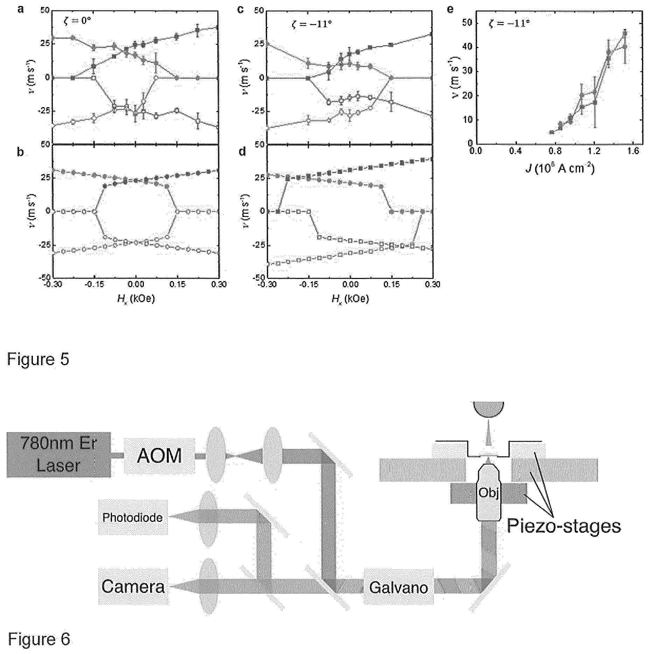

Figure 5 shows the Torsion effect in FM and SAF ribbons. Red (blue) represent $\otimes\odot$ ($\otimes\odot$) DW configurations, respectively, and circle, diamond and square markers represent 0°, +11° and -11° torsion, respectively.

(a)-(d) DW velocity as a function of the applied in-plane field H$_x$ for both DW types moving along +X (solid) and -X (hollow) over sections with 0° (a,c) and -11.31° (b,d) torsion, respectively.
(a)-(b) Experimental data
(c)-(d) Analytical data The parameters for the calculations are $\Delta = 5$ (e) and 3 nm (f-h), $a = 0.1$, $H_k = 159.16$ kA/m (2 kOe), $H_{DM} = -79.58$ kA/m (-1 kOe), for $\odot\otimes$ and 79.58 kA/m (1 kOe), for $\otimes\odot$, $H_{SH} = 0.2$ for $J > 0$ and $H_{SH} = -15.92$ kA/m (-0.2 kOe) for $J < 0$, $M_s = 200$ kA/m (emu cm$^{-3}$), b = 1 $\mu$m, $A_{ex} = 5.2 \times 10$-11 J/m (5.2 ·10$^{-6}$ erg cm$^{-1}$), $V = 1 \times 10^4$ (b) and 6.5 $\times 10^4$ (d) J/m$^3$ (1 · 10$^5$ and 6.5 · 10$^5$ erg cm$^{-3}$), $q_0 = 4$ (b) and 1 nm (d), and $q_{shift} = 10$ nm.
(e)

## Experimental $v - J$ plot for $\zeta = \pm 11°$ in SAF twisted ribbon.

Figure 6 shows a functional diagram of the multi-photon lithography (MPL) system used herein.

Figure 7 shows the Kerr Microscopy setup for measuring the current induced domain wall motion (CIDWM) on the 3D twisted magnetic ribbon structures of the present invention.

**Detailed Description of the Invention**

Definition of terms

The below definition of terms applies to the terms used in singular as well as in plural form.

"Manipulating" or "manipulation" means the precise control of the flow of a DW through a device. It comprises the ability to change the magnetic properties of the DW moving over/along a 3D ribbon, and particularly to change the dynamic magnetic properties such as driving torque, DW velocity, threshold current, DW tilting, tuning of the shift between two DWs, nucleation of DWs, precise stepwise motion of DWs, etc.

"Domain wall" or "DW" means an interface separating magnetic domains. It is a transition between different magnetic moments and usually undergoes an angular displacement of 90° or 180°. A domain wall is a gradual reorientation of individual moments across a finite distance. The domain wall thickness depends on the anisotropy of the material, but on average spans across around 100-150 atoms.

"Chiral" means a magnetic domain, which is distinguishable from its mirror image; i.e., it cannot be superimposed onto itself.

"3D magnetic ribbon" or "3D ribbon" or "ribbon" or "racetrack ribbon" or "3D racetrack ribbon" means a planar object having a length, which is a multiple of its width and which exhibits a three-dimensional shape. In other words, the 3D magnetic ribbon extends between two ends and has at least one twisted region between these two ends, which makes the 3D magnetic ribbon a "curvilinear" 3D magnetic ribbon.

"Twisted region" is a part of the ribbon which exhibits a torsion angle increase or decrease of >0° per unit length.

"Curvilinear" means the shape of an object consisting of, bounded by, or characterized by a curved line.

"Torsion" means the rotation of the structure cross-section along the longitudinal axis of the structure, i.e. means the twisting of an object along it longitudinal direction.

"Torque" is the rotational equivalent of linear force. It is also referred to as the moment of force (also abbreviated to moment). It represents the capability of a force to produce change in the rotational motion of the body. Torque is defined as the product of the magnitude of the perpendicular component of the force and the distance of the line of action of a force from the point around which it is being determined, i.e. the magnetic moment in the context of magnetism.

"Absolute Torsion angle" means total degrees (°) of torsion over the total length of the object, in the present case the at least one twisted region.

"Angle increase per unit length" means the arithmetic average increase (or decrease) in degrees (°) of torsion per unit length.

"Unit length" is a quantity with dimension *distance* having a base unit of *meter.* In the present case, the unit length is preferably $\mu$m or nm; more preferred nm.

Manufacture of 3D Racetrack Ribbons

In general, there are two ways of making the "twisted" ribbons according to the present disclosure.

The first one comprises making a planar ribbon first and then apply at least one permanent torsion to it. This can e.g. be achieved by fabricating a basic supporting ribbon structure made of a stimuli-responsive material (e.g. temperature or electromechanical) with varying thickness along its width such that the basic supporting ribbon structure would have tendency to deform in pre-defined chiral manners when subject to temperature or electrical stimuli. This basic supporting ribbon structure is then covered with magnetic thin film heterostructures (the racetrack) e.g. by magnetron sputtering.

In the second one the at least one twist in the ribbon is "built in" during the manufacturing process by depositing the ribbon on a pre-manufactured basic supporting ribbon structure, which provides the at least one twisted 3D structure. For both manufacturing alternatives e.g. state-of-the-art multi-photon lithography (Hunt, M. et al. Harnessing Multi-Photon Absorption to Produce Three-Dimensional Magnetic Structures at the Nanoscale. Materials 13, 761 (2020) or Harinarayana, V. & Shin, Y. C. Two-photon lithography for three-dimensional fabrication in micro/nanoscale regime: A comprehensive review. Optics & Laser Technology 142, 107180 (2021), Nishiguchi, A. et al. 4D Printing of a Light-Driven Soft Actuator with Programmed Printing Density. ACS Applied Materials & Interfaces 12, 10 (2020)) can be used for making a basic supporting ribbon structure. Typical multi-photon lithography comprises the use of a photoresist, e.g. 7-diethylamino-3-thenoyl-coumarin (DETC), and a monomer, e.g. pentaerythritol triacrylate (PETA).

Thus, according to the disclosure first a sophisticated 3D "scaffold structure" is built, e.g. using multi-photon lithography (MPL), on which magnetic thin film heterostructures (the racetrack) are deposited e.g. by magnetron sputtering. These deposited racetrack layers are the 3D magnetic ribbons, which are the subject matter of the present disclosure.

It is possible to implement two or more twisted regions over the total length of the ribbons, preferably two or three twisted regions. Also, the deposited ribbons may be designed to have a clockwise or anti-clockwise torsion. Two or more twisted regions may have subsequent clockwise or subsequent anti-clockwise torsions, or alternating clockwise and anti-clockwise torsions or any combination thereof.

The curvilinear 3D magnetic ribbons according to the present invention have at least one twisted region between its two ends, wherein each twisted region, independently from one another, has

- a length of 5nm-1000$\mu$m, preferably 10nm-500$\mu$m, more preferred 20nm-50$\mu$m,
- a width of 5nm-20$\mu$m, preferably 5nm-10$\mu$m, more preferred 5nm-5$\mu$m,
- a thickness of 0.1-20nm, preferably 0.1-10nm, more preferred 0.5-5nm, and
- an absolute torsion angle over the total length of 1-70°, preferably 5-55°, more preferred 10-45°, and preferably
- an angle increase per unit length of 0.5-60°/unit length, preferably 0.5-45°/unit length, more preferred 1-20°/unit length.

Preferably, the "non-twisted regions" of the ribbon have the same length, width and thickness as the "twisted regions". In an even more preferred embodiment, all regions, the twisted as well as the non-twisted regions have the same length, width and thickness.

A typical curvilinear 3D ribbon is composed of at least three sections: two ramps, one at each end of the ribbon and a suspended ribbon between the two ramps, eventually with electrical contact leads and pad delimitation. The ramps not only support the suspended ribbon but also allow for electrical access from contact pads to the suspended ribbon. The suspended ribbon typically has at least one, preferably at least two twisted middle region along the longitudinal direction with two different torsion chiralities, and both ends are horizontal with respect to the ground plane on which the ribbon is mounted. In one example, one half of the twisted region may have a left-handed chiral torsion (+) while the other has a right-handed chiral torsion (-). The left and right-handed chiral torsions correspond to positive (anti-clockwise twist seen from the left-side view) and negative (clockwise twist) torsion angles $\zeta$, respectively (see Fig. 1a), where $\zeta$ denotes the angle between the ground plane and the middle section of the ribbon. When $\zeta = 0$, the magnetic ribbon is perfectly horizontal.

After completion of the manufacture of the basic supporting ribbon structure e.g. by multi-photon lithography the ribbon is prepared for deposition of the magnetic racetrack layer(s). The magnetic racetrack layer stacks are deposited onto the substrate e.g. by magnetron sputtering.

The basic structure of a racetrack is based on a ferromagnetic (FM) structure or a synthetic antiferromagnetic (SAF) structure.

The ferromagnetic structure may comprise one or more, preferably two or three layer(s) of a ferromagnetic material. If the ferromagnetic structure comprises more than one layer, preferably two neighboring layers are not identical. The ferromagnetic layer is made of ferromagnetic material e.g.:

- Fe, Co, Ni or Mn, or

- an alloy of Fe and/or Co, or

- an alloy of Ni that may further include one or more of Fe and Co, or

- an alloy of Mn that may optionally further include one or more of Fe, Co or Ni, or

- a compound including Fe and at least one of Ir, Al, Si or Ge, or

- a compound including Mn and Si.

Typically, the ferromagnetic or synthetic antiferromagnetic structure may have a total thickness in the range of 0.1 to 20 nm, ideally 0.5 to 1.5 nm, preferably 0.75 nm to 1.3 nm, more preferred 0.9 nm to 1.2 nm. Each individual layer of the ferromagnetic structure may - independently of one another - have a thickness in the range of 0.1 nm- 1.5 nm, preferably 0.12 nm to 1.0 nm, more preferred 0.14 nm to 0.8 nm.

The ferromagnetic layer(s) of the ferromagnetic structure are preferably sandwiched between a heavy metal (HM) layer and a coupling layer.

The HM layer includes at least one of Pt, Ir, W, Ta or Ru. The HM layer may advantageously have a thickness between 0.8 nm- 2.0 nm, preferably 1.0 nm to 1.8 nm, more preferred 1.2 nm to 1.7 nm.

The coupling layer includes at least one of Ru, W, Ta or Ir. The coupling layer may advantageously have a thickness between 0.4 nm 1.5 nm, preferably 0.6 nm to 1.0 nm, more preferred 0.7 nm to 0.9 nm.

The synthetic antiferromagnetic structure may be comprised of two ferromagnetic layers coupled antiferromagnetically via a coupling layer. In a preferred embodiment, the FM/coupling layer/FM sandwich is deposited on a HM layer. The ferromagnetic layers, the coupling layer and the HM layer are as described above. Preferably, the coupling layer is comprised of Ru or Ir.

Before depositing the racetrack layer(s) onto the basic supporting ribbon structure a layer, e.g. made of TaN may first be deposited as a buffer layer to improve the adhesion and the smoothness of the subsequently applied racetrack films. Capping layers, e.g. also made of TaN, may be used to prevent the oxidation of the magnetic layers for the SAF and FM layers, respectively.

Although the sputtered beams are typically not highly directional or collimated, preferably no films are deposited on the substrate surfaces that are shadowed by the suspended sections of the fabricated basic supporting ribbon structure (= no deposition "under the bridge"). On the other hand, since the substrate is rotated during deposition, the grown films are mostly uniform over the flat and twisted regions in the ribbon.

The curvilinear 3D magnetic ribbons according to the present invention show excellent perpendicular magnetic anisotropy for both the FM and SAF ribbons with strong AF exchange coupling and a small net magnetization for the SAF films. The ribbons exhibit clear asymmetries between the two DW configurations (up|down and down|up). Especially, it was found that at low $J$ one DW configuration becomes stuck near the middle of the ribbon while the other can pass through the ribbon. Most importantly, it was found that this asymmetry also depends on the sign of the torsion chirality (see table in Fig. 2e). Interestingly, when j is high enough (> $1.6 \times 10^8$ A cm$^{-2}$), both DW configurations pass through the ribbon, thus showing that the DW filtering strength can be tuned by $J$. It was also found that the torsion effect on the DW motion increases with increasing $\zeta$ (see table in Fig. 2e).

In the method for manipulating domain walls (DWs) in a magnetic ribbon, a planar magnetic ribbon with a torsion angle of 0° is provided and a DW is nucleated in the ribbon by electric fields or current pulses or a combination of both, then current pulses are used to move the DW along/through the ribbon, wherein the movement of the DW is manipulated by imposing a curvilinear 3D structure upon at least one region of the magnetic ribbon, such that the region exhibits an absolute torsion angle over the twisted region of the ribbon of 1-70°, and the torsion angle has increase per unit length of 0.5-60°.

Manipulation of the DW comprises the change of the magnetic properties of the DW moving over/along the 3D ribbon, and particularly the change of the dynamic magnetic properties such as driving torque, DW velocity, threshold current, DW tilting, tuning of the shift between two DWs, nucleation of DWs, precise stepwise motion of DWs, etc.

The present invention shows a novel interaction between a geometrical chiral torsion and a spin chirality of current driven chiral DW motion in 3D twisted magnetic ribbons. The geometrical chiral torsion induces a unidirectional exchange field that breaks symmetry and favors Bloch walls, thereby giving rise to chiral torsion torques that are distinct from conventional interface DMI torques. These findings enable applications for the current-driven manipulation of chiral DWs in 3D twisted structures, thereby allowing for new device functionalities and performances including a diode effect as demonstrated in the Examples.

The invention will now be explained in more detail in the following Examples.

### EXAMPLES

Magnetic thin films were deposited by magnetron sputtering (see Methods for details). First, a 100 thick TaN layer is deposited that acts as both a buffer and an adhesion layer to improve the smoothness of the MPL structure surface and minimize associated defects (thicknesses are in Å here and hereafter). Then a 30 Pt layer is grown as a source of SOT. Magnetic layer stacks are formed from 3 Co/7 Ni/3 Co and 3 Co/7 Ni/1.5 Co/9.5 Ru/3.5 Co/7 Ni/3 Co for FM and SAF films, respectively. TaN layers, 60 and 30 thick, are used as capping layers, respectively. The RMS surface roughness measured by AFM is found to be ~0.37 nm in the twisted region with $\zeta$ = +11° (as compared with ~0.1 nm RMS roughness for the substrate itself) (see Fig.1f). Cross-sectional transmission electron microscopy (XTEM) on the region with $\zeta$ = +11° shows that the grown films are uniform and conformally grow on the ribbon surface except near the edge areas in which the films are thinner with a thickness gradient (Fig. 1f). No film was found to be deposited onto the shadowed areas or the backside of the suspended ribbon. The thinner regions at the ribbon edges can cause DW pinning during current-driven motion. The grown films show excellent perpendicular magnetic anisotropy for both the FM and SAF films with strong AF exchange coupling and a small net magnetization for the SAF films. Current induced domain wall motion was measured using polar Kerr microscopy in a differential mode (Fig. 1c and see the Methods for more details). A sequence of current pulses with a minimum pulse length $t_p$ =10 ns is applied between each Kerr image acquisition. $t_p$ was increased up to 30-50 ns when $J$ is low while $t_p$ was reduced for high $J$ since the larger $t_p$ often heats up the suspended 3D structures that are rather poorly thermally connected to the substrate.

First, the DW displacements by current pulses in the twisted magnetic ribbons are investigated as a function of the cumulative pulse lengths (Fig. 2b). Magnetic ribbons formed from a single FM layer with no torsion show nearly the same DW displacement for both DW configurations for all $J$, as expected (Fig. 2b). On the other hand, the twisted ribbons clearly exhibit clear asymmetries between the two DW configurations. Especially, it was found that at low $J$ one DW configuration becomes stuck near the middle of the ribbon while the other can pass through the ribbon. Most importantly, it was found that this asymmetry also depends on the sign of the torsion chirality (see table in Fig. 2e). Interestingly, when $J$ is high enough ($> 1.6 \times 10^8$ A cm$^{-2}$), both DW configurations pass through the ribbon, thus showing that the DW filtering strength can be tuned by $J$. It was found that the torsion effect on the DW motion increases with increasing $\zeta$ (see table in Fig. 2e). However, more defects are more likely to be incorporated in the ribbon with increasing $\zeta$, thus increasing $J_c$ and decreasing the nucleation current density $J_{nuc}$ and limiting the stability of the DW motion for $|\zeta| \geq 18°$. Hence, the focus is on devices with $\zeta = \pm 11°$, hereafter.

For positive current polarity, $\odot\otimes$ DW moves faster than $\otimes\odot$ DW in the +11° torsion region while the velocity of $\otimes\odot$ DW is higher than $\odot\otimes$ DW in the -11° torsion region (Fig. 2b and c). Vice versa for the negative current polarity as shown in the insets to Fig. 2b and c. Moreover, the faster DW shows lower $J_c$ ($\sim 8 \times 10^7$ A cm$^{-2}$) than the slower counterpart ($\sim 1.2 \times 10^8$ A cm$^{-2}$). Thus, the $\otimes\odot$ DW is filtered when $8 \times 10^7 < J_c < 1.2 \times 10^8$ A cm$^{-2}$ while the $\odot\otimes$ DW is filtered for the opposite current polarity. Note that the asymmetry in DW velocity decreases with increasing $J$, as shown in Fig. 2b and 3.

The following discusses of the underlying mechanism of how the torsion affects the current driven motion of DWs. It is assumed that (i) the DW width is much smaller than the ribbon width, as expected for our devices for which the DW width is estimated to be ~10 nm, (ii) the DW tilting angle $\chi$ is small, and (iii) $J$ is not large. Note that the polar angle $\theta$ of the DW magnetization changes from 0 ($\pi$) to n (0) for $\odot\otimes$ ($\otimes\odot$) DW configurations for perpendicularly magnetized domains. That is, $\odot$ and $\otimes$ correspond to $\theta = 0$ and $\pi$, respectively, in the moving frame coordinates ($\hat{p}, \hat{r}, \hat{u}$) as shown in Fig. 4a. ($\hat{p}, \hat{r}, \hat{u}$) are a set of unit vectors at the ribbon surface while ($\hat{x}, \hat{y}, \hat{z}$) correspond to the static frame coordinates (see Fig. 4a). On the other hand, the azimuthal angle $\phi$ of the magnetization not only determines the type of DW, i.e., $\phi = 0, \pi$ (Néel) and $\frac{\pi}{2}, \frac{3\pi}{2}$ (Bloch) but strongly affects the magnetic exchange energy, $E_{ex}$ depending on the torsion chirality (Fig. 4a,b). Note that the larger (steeper) magnetization gradients within DWs give rise to larger $E_{ex}$, since $E_{ex} = A_{ex}|\nabla\hat{M}|^2$ where $A_{ex}$ is the exchange stiffness and $\hat{M} = \dfrac{\vec{M}}{|\vec{M}|}$ (the magnetization unit vector). For the Néel-type wall case, $E_{ex}(\phi = 0) = E_{ex}(\phi = \pi)$, corresponding to a medium value of $E_{ex}$ as shown in Fig. 4a and b.

In contrast, $E_{ex}$ forms a minimum and a maximum for the Bloch-type DWs depending on the DW configuration and torsion chirality (Fig. 4a,b). For example, $E_{ex}$ is lowest at $\phi = \dfrac{\pi}{2}$ for $\odot\otimes$ (i.e. $\odot\uparrow\otimes$) for positive torsion chirality ($\zeta > 0$). In this case, $\hat{M}$ rotates in the same direction as the ribbon twists around its length direction p such that $\hat{M}$ within the DW rotates less than the case without any torsion, i.e. the gradient of $\hat{M}$ becomes smaller. If the DW width were identical to the length of the $\pi$-twisted region, then $\hat{M}$ would be perfectly uniform within the DW, thus effectively equivalent to a single magnetic domain. On the other hand, $E_{ex}$ is largest at $\phi = \dfrac{3\pi}{2}$ for the same configuration ($\odot\downarrow\otimes$) and $\zeta > 0$, since the DW magnetization rotates in the opposite direction as the ribbon twists around the $\hat{p}$-direction. Thus, this gives rise to a steep rotation and large gradient of $\hat{M}$ within the DW. This difference in $E_{ex}$ between $\phi = \dfrac{\pi}{2}$ (minimum $E_{ex}$) and $\phi = \dfrac{3\pi}{2}$ (maximum $E_{ex}$) generates an effective torsion field $\vec{H}_{tor} = -\dfrac{\partial E_{ex}}{\partial \vec{M}} = \eta \dfrac{2A_{ex}}{M_s b \Delta}\hat{r}$ that is along $\phi = \dfrac{\pi}{2}$ direction ($\uparrow$) for positive torsion, as shown in Fig. 4c. Here b is the torsion parameter (see model description in Methods), $M_s$ is the saturation magnetization, $\Delta$ is the DW width parameter, and $\eta = +1$ ($\odot\otimes$), -1 ($\otimes\odot$). As for the $\otimes\odot$ DW, $E_{ex}$ forms a maximum (minimum) at $\phi = \dfrac{\pi}{2}$ ($\phi = \dfrac{3\pi}{2}$) such that the difference in $E_{ex}$ changes sign, thereby leading to $\vec{H}_{tor}$ along $\phi = \dfrac{3\pi}{2}$ direction ($\downarrow$). When the torsion chirality is changed, the sign of $b$ switches, the maximum and minimum of $E_{ex}$ are swapped, and consequently the orientations of $\vec{H}_{tor}$ are reversed (Fig. 4d).

Note that $\vec{H}_{tor}$ induces unidirectionality and torsion chirality by breaking uniaxial symmetry, thereby favoring a chiral Bloch-type wall. Consequently, $\vec{H}_{tor}$ gives rise to a chiral torsion torque, $\vec{\tau}_{tor} = -\gamma\vec{M} \times \vec{H}_{tor}$, on $\vec{M}$ where $y$ is the gyromagnetic ratio. If the volume spin transfer torque and the anisotropy field torque due to the shape anisotropy of DW are neglected, the total DW velocity is determined by $\vec{\tau}_{tor} + \vec{\tau}_{DM}$. Note that $\vec{\tau}_{DM} = -\gamma\vec{M} \times \vec{H}_{DM}$ is the DMI torque, the main driving torque to move the chiral DWs by the DMI field $\vec{H}_{DM} = -\dfrac{\partial E_{DM}}{\partial \vec{M}} = -\eta \dfrac{D}{\pi\Delta}\hat{p}$, favoring a Néel-type wall from the Pt/Co interface e.g. $\odot\leftarrow\otimes$ ($\phi = \pi$) and $\otimes\rightarrow\odot$ ($\phi = 0$) for the left-handed chirality in the Pt/Co system. Here $E_{DM}$ and $D$ are the DMI energy density and DMI constant, respectively. Hence, the DW is neither purely Néel-type nor Bloch-type in the absence of current such that $\phi$ is determined by $\vec{H}_{tor} + \vec{H}_{DM}$, that is, $\phi = \arctan\dfrac{H_{tor}}{H_{DM}}$ (here the DW shape anisotropy field is neglected, for simplicity). For example, $\phi \sim \frac{\pi}{12}$ using parameters that fit the experimental CIDWM data for $\zeta = \pm 11°$ shown in Fig. 3b and c.

The application of charge current to the magnetic ribbon gives rise to a spin current, owing to the spin Hall effect (SHE) in the Pt underlayer. This spin current is chiral since the directions of the spin polarization $\vec{S}$, charge current $J$ and spin current $J_s$ are mutually orthogonal to each other in a handed manner. The chirality of the spin current is determined by the sign of the SHE. For example, for the Pt/Co system, the spin current is left-handed, i.e. $J \parallel +\hat{p}$, $\vec{S} \parallel +\hat{r}$, and $J_s \parallel +\hat{u}$. This chiral spin current exerts a damping-like SOT on M, thereby bringing $\vec{M}$ toward $\vec{S}$ and, consequently, placing $\vec{M}$ in a specific quadrant of the plane defined by $\hat{p}$ and $\hat{r}$ (insets in Fig. 4a). For example, when $\vec{M}$ is in the 3$^{rd}$ quadrant, that corresponds to the case $J \parallel +\hat{p}$ and $\vec{H}_{DM} \parallel -\hat{p}$ for the $\odot\otimes$ (left upper panels in Fig. 4c,d), $\vec{\tau}_{DM}$ is along $+\hat{u}$. At the same time, if there exists $\vec{H}_{tor} \parallel +\hat{r}$ that corresponds to $\odot\otimes$ with $\zeta > 0$ (left panels in Fig. 4c), $\vec{\tau}_{tor}$ is along $+\hat{u}$. Consequently, the total torque $\vec{\tau} = \vec{\tau}_{tor}(\odot) + \vec{\tau}_{DM}$ ($\odot$) moves the $\odot\otimes$ DW faster (left upper panel in Fig. 4c). On the other hand, when the torsion chirality switches such that $\zeta < 0$, $\vec{H}_{tor} \parallel -\hat{r}$ and $\vec{\tau}_{tor}$ is along $-\hat{u}$ so that $\vec{\tau} = \vec{\tau}_{tor}(\odot) + \vec{\tau}_{DM}(\otimes)$ moves $\odot\otimes$ DW slower (left upper panel in Fig. 4d). The other cases can be readily accounted for by this mechanism, as shown in Fig. 4c,d. Note, interestingly, that $\vec{\tau}_{tor}$ always points along $+\hat{u}$ ($\odot$) for $\zeta > 0$ while it is aligned along $-\hat{u}$ ($\otimes$) for $\zeta < 0$, irrespective of the DW configuration and current direction. This chiral torsion induced asymmetry is distinct from $\vec{\tau}_{DM}$, the direction of which switches as the DW configurations and current directions are reversed, thereby showing the unique asymmetry of $\vec{\tau}_{tor}$.

Next the torsion effect as a function of $J$ and ribbon width w is investigated. Since the SOT that is proportional to $J$ brings $\vec{M}$ closer to $\phi = \frac{\pi}{2}$ or $\frac{3\pi}{2}$ (Bloch-type wall) with increasing $J$, $\tau_{tor}$ and $v_{tor}$ decrease with increasing $J$. This is distinct from $\tau_{DM}$ and $v_{DM}$ that monotonically increase but saturate with increasing $J$. Note that, at $\phi = \frac{\pi}{2}$ or $\frac{3\pi}{2}$, $\tau_{tor}$ is zero while $\tau_{DM}$ is a maximum. Consequently, $\delta v_{tor} = v_{tor}(\zeta > 0) - v_{tor}(\zeta < 0)$ increases with decreasing $J$, thereby leading to a sizable difference in $J_c$, as shown in our experimental observations and model that assumes identical pinning potentials for both torsion chiralities (Fig. 3b,c,e,f). On the other hand, it was found that the w-dependence of $\delta v_{tor}$ is small for a given $\zeta$, as shown in Fig. 4d, since $\tau_{tor}$ is independent of w (see Methods). This is distinct from 2D curved ribbons in which the velocity difference increases with $w/R$ where $R$ is the radius of curvature. Moreover, $v_{tor}$ is independent of $\Delta$ (see Methods), which is similar to the volume spin-transfer torque driven velocity $v_{STT}$ but distinct from $v_{DM}$ that is proportional to $\Delta$. This is because $E_{ex}$ increases with decreasing $\Delta$ for a given $\zeta$, thereby leading to $H_{tor} \propto \frac{1}{\Delta}$ and $\tau_{tor} \propto \frac{1}{\Delta}$ (see Methods). Note that the DW displacement and velocity with a given torque is linearly proportional to $\Delta$, i.e. $v_{DM} \propto \tau_{tor}\Delta$ such that $v_{tor}$ is constant with respect to $\Delta$.

The longitudinal field $H_x$ dependence of $v$ provides additional insight into the interaction of the different chiralities since $H_x$ plays an equivalent role to $H_{DM}$ by effectively adding to or subtracting $H_{DM}$. $v$ - $H_x$ curves are nearly symmetric for the magnetic ribbons with no torsion. On the other hand, the curves show marked asymmetries with respect to not only $v$ but also $H_x$ due to the chiral torsion effects, as shown in Fig. 5a-d. The asymmetry in $v$ increases with increasing $|H_x|$ since $H_x$ brings $\vec{M}$ to $\phi = 0$ or $\pi$ (Néel-type wall) and $\tau_{tor}$ increases for a given SOT (Fig. 5). For example, for the $\otimes\odot$ ($\odot\otimes$) configuration with $\zeta = -11°$, a positive (negative) $H_x$ brings the DW magnetization closer to $\phi = 0$ ($\pi$) thus increasing the magnitude of $v_{tor} > 0$ ($< 0$) that is added to (subtracted from) $v_{DM}(> 0)$ in the presence of $J > 0$. In contrast, when $J < 0$, $v_{DM}$ changes sign from positive to negative, while the sign of $v_{tor}$ does not change, so that $v_{tor} > 0$ ($< 0$) is subtracted from (added to) $v_{DM}(< 0)$ for the $\otimes\odot$ ($\odot\otimes$) configuration.

Finally, current-induced DW motions were investigated in the SAF 3D ribbons. It is observed that the torsion effect vanishes in these ribbons, as shown in Fig. 5e. This can be accounted for by the fact that $\tau_{tor}$ on the component DW in the upper sublayer compensates that in the lower sublayer, since the DW configurations for both sublayers are opposite to each other. This is akin to observations in curved 2D ribbons.

METHODS

**Multi-Photon Lithography**

To fabricate the 3D twisted ribbons, a super-resolution STED microscope (Abberior Instruments GmbH, Germany) was adapted extensively both in hardware and software, so as to perform multi-photon lithography (MPL). A functional diagram of the system is shown in Figure 6. A femtosecond Er fiber laser (Menlo Systems C-Fiber 780) is used to generate multi-photon excitation at 80MHz repetition rate and at a wavelength of 780nm. The optical pulse power is controlled by an acousto-optic modulator (AOM) prior to focusing the beam onto a liquid photoresist through a Nikon Plan Apo Lambda 100x/1.45 Oil objective lens. Precise motions of the objective along the optical axis (z-axis) are controlled by the combination of a motorized focus stage embedded in the microscope (Nikon Ti-2, working distance: 10 mm) and an XYZ piezostage (Physik Instrumente P-545.3C8S Plnano, working distances: 200 $\mu$m for all axes). XY-motions are achieved by the combination of a XYZ piezo-stage and a coarse motion stage (Physik Instrumente U-780 PILine XY-stage: working distances: 135mm (x-axis) and 85mm (y-axis)). The coarse motion stage allows for the fabrication of large structures such as the contact pads.

The fabrication process is as follows: first, one drop of photoresist is applied onto a borosilicate glass coverslip that is placed on the microscope sample stage. The glassphotoresist interface is automatically positioned by monitoring the reflection from the substrate surface using a photodiode. The interface positioning errors are < 200 nm. To improve adhesion, the fabrication is begun with the laser focused inside the substrate. During the fabrication, the laser is scanned along the XY-axes using a set of galvano-scanners (maximum scanning range of 80 $\mu$m) and along the Z-axis using an XYZ piezostage. The photoresist used for fabrication is composed of 7-diethylamino-3-thenoyl-coumarin (DETC, Luxottica Exciton) as the photo-initiator, 0.25wt% concentration, and pentaerythritol triacrylate (PETA, Merck Sigma-Aldrich) as the monomer. The photoresist is prepared by precisely weighing each component chemical and mixing them with a magnetic stirrer for 20-40 minutes at room temperature until the photoinitiator is observed to be completely dissolved in the monomer. This type of photoresist has been widely used and characterized in previous experiments with STED-MPL. Laser excitation pulses with 0.2 nJ energy are applied at a 80MHz repetition rate. The laser is XY-scanned at a speed of 6.25mm/s with the galvano-scanner. To reduce the surface roughness, the scanning step interval is set to be 25 nm along the X and Z axes. After the illumination, the unpolymerized photoresist is removed by submerging the sample in propylene glycol monomethyl ether acetate (PEGMEA, Merck Sigma-Aldrich) for 25 min, followed by submersion in 2-propanol for 5 min. Finally, the sample is carefully dried with dust-free compressed air to avoid residue or dust on the surface.

### Film growth

After the multi-photon lithography process is completed, the glass substrate is cut into smaller pieces in preparation for deposition. The magnetic film stacks are deposited onto both the polymer structures and glass substrate by magnetron sputtering at an Ar pressure of $10^{-3}$ Torr at room temperature. The deposition system has a base pressure better than $10^{-9}$ Torr. The film growth rates are ~ 0.9 Å/s for Pt, and ~ 0.2 Å/s for FM and Ru films. A 100 Å thick TaN layer is first deposited to improve the adhesion and the smoothness of the following films. TaN capping layers, 30 and 60 Å thick, are used to prevent the oxidation of the magnetic layers for the SAF and FM films, respectively. Full film stacks are 100 TaN/30 Pt/3 Co/7 Ni/3 Co/60 TaN and 100 TaN/30 Pt/3 Co/7 Ni/1.5 Co/9.5 Ru/3.5 Co/7 Ni/3 Co/30 TaN for FM and SAF films, respectively (all thicknesses are in Å). Although the sputtered beams are not highly directional or collimated, no films are deposited on the substrate surfaces that are shadowed by the suspended sections of the fabricated structure. On the other hand, since the substrate is rotated during deposition, the grown films are mostly uniform over the flat and twisted regions in the ribbons.

### Atomic Force Microscopy (AFM)

An Asylum Research Cypher atomic force microscope is used to check the roughness of the deposited films. The suspended region of the 3D device with +11° torsion together with a contiguous section of the substrate is scanned along the ribbon direction in tapping (AC) mode to minimize the perturbations at the ribbon edges. The pixel size was set to 10 nm with a scan rate of 0.3 Hz and a voltage of 600 mV. The values given in the paper correspond to the root mean square of roughness, $R_q$.

### Kerr Microscopy

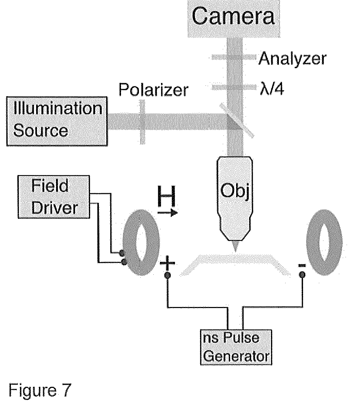

Current induced domain wall motion on the 3D twisted magnetic ribbon structures is measured using polar Kerr microscopy at room temperature (see Figure 7). The polarizer in the Kerr microscope linearly polarizes the incident light. On the other hand, a $\lambda$/4 waveplate is combined with an analyzer to measure the Kerr ellipticity, allowing the magnetization contrast along the Z-axis to be detected. Devices are ribbon-bonded via contact pads. The device resistances are measured before and after the characterization to probe for significant changes in the devices such as deformations from Joule heating, with variations typically < 1 %. A nanosecond pulse generator is used to move the DWs. The rise and fall times of the voltage pulses are 0.3 and 0.8 ns, respectively. Pulse lengths longer than 10ns are typically applied unless domain wall nucleation is observed. Sometimes 8 ns long pulses are used when higher voltage pulses are needed for the experiment and 10 ns pulses are observed to promote nucleation (due to heating effects).

First, a DW is nucleated at either end of the ribbon by fields or current pulses or a combination of both. Then the DW is driven into the twisted region by sequences of current pulses. Differential mode Kerr microscopy is employed: an initial image is used as the background that is subtracted from the image being acquired after a sequence of current pulses have been applied. This process significantly improves the magnetic contrast and resolution of images by minimizing the effect of drift and vibrations on the Kerr contrast. Consequently, the processed Kerr image shows two boundaries in the ribbon that correspond to the prior and present DWs positions. These complete process cycles (DW nucleation and motion) are automatized and repeated 3-5 times to check the reproducibility and for statistics. The current pulse length is limited to avoid Joule heating of the ribbons that are poorly thermally connected to the surface.

The upper bound of $J$ is limited by DW nucleation while the lower bound corresponds to $J_c$ below which the speed of the DW is less than 5 m s$^{-1}$. In each measurement cycle, a DW is attempted to be driven along the whole ribbon by applying a sequence of current pulses. Each Kerr image is acquired after the application of current pulses, corresponding to the DW displacement during the pulses (Fig. 7). A 10 ns long pulse is typically used although 7ns and 30-50ns long pulses are employed for higher and lower $J$, respectively. Each cycle is repeated 3 times to check reproducibility. As for the magnetic ribbon with -45° torsion, the sample is placed on a wedge at 22.5° angle to enhance the Kerr image contrast.

### Data Processing

A semi-automatic classification algorithm is developed to locate domain wall positions from the acquired images. First, a denoising process is applied to each image during the acquisition cycle by image reconstruction using a multi-stage progressive image restoration (Zamir, S. W. et al. Multi-Stage Progressive Image Restoration. arXiv:2102.02808 (2021)). After denoising, the ribbon edges are automatically detected, after which the reconstructed images are normalized, and the contours of the magnetization shade are detected/filtered based on the area and aspect ratio. The resulting contour candidates are presented to the user for selection. The domain wall positions are determined from the boundaries of selected contours, from which the velocity is calculated based on the input parameters, such as pulse lengths. The average velocity along the ribbon is obtained from the initial and final positions of the DWs for each measurement cycle and the corresponding number of applied pulses.

### Vibrating sample magnetometry

The magnetic properties of unpatterned films are characterized by measuring the easyaxis (out-of-plane) and hard axis (in-plane) loops with a vibrating sample magnetometer (Lakeshore VSM 8600) at room temperature. The applied field range is $\mp$1591.6 kA/m (20 kOe) (easy axis for SAF films and hard axis) and $\pm$ 159.16 kA/m (2 kOe) (easy axis for FM films).

### Cross-sectional transmission electron microscopy

The uniformity of the film deposition about a cross-section of a device was characterized for a -11° torsion device through transmission electron microscopy (TEM). TEM sample preparation was performed using a TESCAN GAIA3 FIB-SEM workstation. First, the suspended sections of the devices were coated with protective layers of C and Pt utilizing focused electron and ion (Ga) beam induced deposition, Then, a small slice of the device cross section in the middle of the suspended section was cut for each device, attached to a Cu TEM-grid and gradually polished with decreasing beam current. A final, low energy polishing step was performed to clean the exposed surfaces from implanted Ga ions. During the electron beam induced deposition, the suspended section of the device was seen to deform, leading to the surface curvature and indentation noticeable in the left side of figure 1f, but the deformation did not influence the characterization outcome since the film thickness over the polymer scaffold was unaffected and the sliced cross-sections were not further modified during the remainder of the process. High resolution TEM characterization of the processed cross-section was performed using a JEOL JEM-F200 microscope, at 200kV.

### Chiral torsion fields and torques

A twisted magnetic ribbon can be described by the following parametric equations, when the torsional axis is $x$ around which the magnetic ribbon is twisted: $p = x$, $r = y \cos \frac{x}{b}$, and $u = y \sin \frac{x}{b}$, where (x, y, z) are the stationary cartesian coordinates while (p, r, u) correspond to the coordinates fixed on the twisted ribbon surface. $b$ measures how much the ribbon is twisted such that the torsion $\xi = \frac{b}{b^2+y^2}$ is determined by $b$. Note that the sign of $b$ corresponds to the chirality of torsion. $\hat{p}$ and $\hat{r}$ are unit tangential vectors, and $\hat{u}$ is a unit normal vector for the moving frame:

$$\hat{p} = \text{sign}(b)\frac{b\hat{x}+y\hat{z}}{\sqrt{b^2+y^2}}, \hat{r} = -\text{sign}(b)\sin\frac{x}{b}\frac{y\hat{x}-b\hat{z}}{\sqrt{b^2+y^2}} + \hat{y}\cos\frac{x}{b} \qquad , \qquad \text{and}$$

$$\hat{u} = -\text{sign}(b)\cos\frac{x}{b}\frac{y\hat{x}-b\hat{z}}{\sqrt{b^2+y^2}} - \hat{y}\sin\frac{x}{b}$$ (see the inset of Fig. 3a). Then the unit magnetization $\hat{m}$ can be written as

$$\hat{m} = \sin\theta\cos\phi\,\hat{p} + \sin\theta\sin\phi\,\hat{r} + \cos\theta\,\hat{u} =$$

$$\text{sign}(b)\frac{b\sin\theta\cos\phi-y\sin\theta\sin\phi\sin\frac{x}{b}-y\cos\theta\cos\frac{x}{b}}{\sqrt{b^2+y^2}}\hat{x} + \left(\sin\theta\sin\phi\cos\frac{x}{b}-\cos\theta\sin\frac{x}{b}\right)\hat{y} +$$

$$\text{sign}(b)\frac{y\sin\theta\cos\phi+b\cos\theta\cos\frac{x}{b}+b\sin\theta\sin\phi\sin\frac{x}{b}}{\sqrt{b^2+y^2}}\hat{z}$$ , $\theta$ and $\phi$ are the polar and azimuthal angles of DW magne-

tization with respect to $\hat{u}$ and $\hat{p}$ directions, respectively. Consequently, the exchange energy per unit volume

$$E_{ex} = A_{ex}(\nabla\hat{m})^2 = A_{ex}\left[\left(\frac{\partial m_x}{\partial x}\right)^2 + \left(\frac{\partial m_y}{\partial x}\right)^2 + \left(\frac{\partial m_z}{\partial x}\right)^2 + \left(\frac{\partial m_x}{\partial y}\right)^2 + \left(\frac{\partial m_y}{\partial y}\right)^2 + \left(\frac{\partial m_z}{\partial y}\right)^2\right]$$ where $A_{ex}$

is the exchange stiffness constant. Since $\theta = 2\arctan\exp\left[\pm\frac{(x-q)\cos\chi+y\sin\chi}{\Delta}\right]$ for the DW magnetization,

$$E_{ex} = A_{ex}\left[\frac{\sin^2\theta}{\Delta^2} - \frac{2}{b}\frac{\sin\theta}{\Delta}\sin\phi\cos\chi - 2\xi\frac{\sin\theta}{\Delta}\cos\phi\cos\phi\sin\chi - \frac{1}{b^2}\sin^2\theta\cos^2\phi + \right.$$

$$\left.\xi^2\left(\sin^2\theta\sin^2\phi\sin^2\frac{x}{b} - \sin^2\theta\cos^2\frac{x}{b} + \sin^2\theta\cos^2\phi + \frac{1}{2}\sin 2\theta\sin\phi\sin\frac{2x}{b}\right)\right]$$ , where $q$ is the DW

position, $\chi$ is the DW tilting angle with respect to $\hat{r}$, and $\Delta$ is the DW width parameter.

The equations of motion are

$$(1+\alpha^2)\dot{q} = \mp\frac{\gamma\Delta}{M_s}K_0\sin 2(\phi-\chi)\sec\chi \pm \frac{\pi\gamma\Delta}{2}\sec\chi\left[H_p\sin(\phi-\phi_H)+H_{DMI}\sin(\phi-\chi)\right]\mp$$

$$\frac{\pi}{2}\alpha\gamma H_{SH}\Delta\cos\phi\sec\chi - \frac{\pi\gamma A_{ex}}{bM_s}\cos\phi + 4\gamma A_{ex}\sin\frac{\pi\Delta\sec\chi}{2b}\left(\frac{b}{\Delta}\sin\phi\cos\chi\cos\frac{q}{b} - \right.$$

$$\alpha\cos\phi\sin\frac{q}{b}\right)\left[0.4\cot\chi\left(1-\cos\frac{w\tan\chi}{2b}\right) + \left(1-\frac{0.2w}{b}\right)\sin w\tan\frac{x}{2b}\right] + \frac{\gamma A_{ex}\Delta}{2b^2 M_s}\sin 2\phi\sec\chi -$$

$$\frac{\gamma A_{ex}}{2wM_s}\sin\frac{2\Delta\sec\chi}{b}\cot\chi\left[\sin 2\phi\cos\frac{2q}{b} + \frac{2\alpha\Delta}{b}\sec\chi(1+\sin^2\phi)\sin\frac{2q}{b}\right]\left[0.3\cot\chi\left(1-\right.\right.$$

$$\cos\frac{w\tan\chi}{b}\right) + \left(1-\frac{0.3w}{b}\right)\sin\frac{w\tan\chi}{b}\right] - \frac{2\alpha\gamma A_{ex}\Delta}{wbM_s}\left[0.3\cot\chi\left(\cot\chi-\cot\chi\cos\frac{w\tan\chi}{b} - \right.\right.$$

$$\frac{w}{b}\sin\frac{w\tan\chi}{b}\right)\left(\sin\frac{2q}{b} + \sin\frac{\pi\Delta\sec\chi}{b}\cos\frac{2q}{b}\right) + \cot\chi\sin\frac{\pi\Delta\sec\chi}{b}\left(\sin\frac{2q}{b} + \cos\frac{2q}{b}\right)\right]$$ ,

$$(1+\alpha^2)\dot{\phi} = \frac{\alpha\gamma}{M_s}K_0\sin 2(\phi-\chi) - \frac{\alpha\pi\gamma}{2}\left[H_p\sin(\phi-\phi_H)+H_{DMI}\sin(\phi-\chi)\right] -$$

$$\frac{\pi}{2}\gamma H_{SH}\cos\phi \pm \frac{\alpha\pi\gamma A_{ex}}{bM_s\Delta}\cos\phi\cos\chi \mp \frac{4\gamma A_{ex}}{wM_s\Delta}\cos\chi\sin\frac{\pi\Delta\sec\chi}{2b}\left(\frac{\alpha b}{\Delta}\sin\phi\cos\chi\cos\frac{q}{b} + \right.$$

$$\cos\phi\sin\frac{q}{b}\right)\left[0.4\cot\chi\left(1-\cos\frac{w\tan\chi}{2b}\right) + \left(1-\frac{0.2w}{b}\right)\sin\frac{w\tan\chi}{2b}\right] \mp \frac{\alpha\gamma A_{ex}\Delta}{2b^2 M_s}\sin 2\phi \pm$$

$$\frac{\gamma A_{ex}}{2wM_s\Delta}\sin\frac{2\Delta\sec\chi}{b}\cot\chi\left[\alpha\cos\chi\sin 2\phi\cos\frac{2q}{b} - \frac{2\Delta}{b}(1+\sin^2\phi)\sin\frac{2q}{b}\right]\left[0.3\cot\chi\left(1-\right.\right.$$

$$\cos\frac{w\tan\chi}{b}\right) + \left(1-\frac{0.34w}{b}\right)\sin\frac{w\tan\chi}{b}\right] \mp \frac{2\gamma A_{ex}}{wbM_s}\left[0.3\cot\chi\left(\cot\chi-\cot\chi\cos\frac{w\tan\chi}{b} - \right.\right.$$

$$\frac{w}{b}\sin\frac{w\tan\chi}{b}\right)\left(\sin\frac{2q}{b} + \sin\frac{\pi\Delta\sec\chi}{b}\cos\frac{2q}{b}\right) + \cot\chi\sin\frac{\pi\Delta\sec\chi}{b}\left(\sin\frac{2q}{b} + \cos\frac{2q}{b}\right)\right]$$ ,

$$\frac{\pi^2\alpha}{6\gamma}\left[\left(\frac{w}{\pi\Delta}\right)^2\sec^2\chi + \tan^2\chi\right]\dot{\chi} = -\frac{\sigma}{M_s\Delta}\tan\chi + \pi H_{DM}\sin(\phi-\chi) - H_k\sin 2(\phi-\chi)\mp$$

$$\frac{4A_{ex}}{wM_s\Delta}\cos\phi\cos\frac{q}{b}\left(\frac{b}{\Delta}\sin 2\chi\sin\frac{\pi\Delta\sec\chi}{2b} - \pi\sin\chi\cos\frac{\pi\Delta\sec\chi}{2b}\right)\left[0.4\cot\chi\left(1-\cos\frac{w\tan\chi}{2b}\right)+\right.$$

$$\left(1-\frac{0.2w}{b}\right)\sin\frac{w\tan\chi}{2b}\right] \mp \frac{8bA_{ex}}{wM_s\Delta^2}\cos\phi\cos\frac{q}{b}\sin\frac{\pi\Delta\sec\chi}{2b}\left\{0.4\cot\chi\left[\cot\chi\left(1-\cos\frac{\pi\Delta\sec\chi}{2b}\right)-\right.\right.$$

$$\left.\frac{w}{2b}\sin\frac{\pi\Delta\sec\chi}{2b}\right] - \left(1-\frac{0.2w}{b}\right)\frac{w}{2b}\cos\frac{\pi\Delta\sec\chi}{2b}\right\} \pm \frac{A_{ex}}{wM_s\Delta}(1+$$

$$\sin^2\phi)\cos\chi\cos\frac{2q}{b}\left\{\left(\frac{2\Delta}{b}\sec\chi\cos\frac{2\Delta\sec\chi}{b} - \csc^2\chi\sin\frac{2\Delta\sec\chi}{b}\right)\left[0.3\cot\chi\left(1-\cos\frac{w\tan\chi}{b}\right)+\right.\right.$$

$$\left(1-\frac{0.3w}{b}\right)\sin\frac{w\tan\chi}{b}\right] + 0.34\sin\frac{2\Delta\sec\chi}{b}\cot\chi\left[\csc^2\chi\left(\cos\frac{2\Delta\sec\chi}{b}-1\right)\right]+$$

$$\frac{w}{b}\sec\chi\left(\csc\chi\sin\frac{w\tan\chi}{b} - \sec\chi\cos\frac{w\tan\chi}{b}\right)\right\} \mp \frac{2A_{ex}}{wM_s\Delta}\cos\chi\csc^2\chi\left[0.3\cot\chi\left(\cot\chi-\right.\right.$$

$$\cot\chi\cos\frac{w\tan\chi}{b} - \frac{w}{b}\sin\frac{w\tan\chi}{b}\right)\left(\cos\frac{2q}{b} - \sin\frac{\pi\Delta\sec\chi}{b}\sin\frac{2q}{b}\right) + \sin\frac{\pi\Delta\sec\chi}{b}\left(\cos\frac{2q}{b} - \sin\frac{2q}{b}\right)\right] \pm$$

$$\frac{2A_{ex}}{wM_s\Delta}\cos\chi\cot\chi\left\{0.3\left[\csc^2\chi\left(\cos\frac{w\tan\chi}{b}-1\right) + \frac{w}{b}\sec\chi\left(\csc\chi\sin\frac{w\tan\chi}{b}-\right.\right.\right.$$

$$\sec\chi\cos\frac{w\tan\chi}{b}\right)\left(\cos\frac{2q}{b} - \sin\frac{\pi\Delta\sec\chi}{b}\sin\frac{2q}{b}\right) + \frac{\pi\Delta\sec\chi\tan\chi}{b}\cos\frac{\pi\Delta\sec\chi}{b}\left[\cos\frac{2q}{b} - \sin\frac{2q}{b}\left[1+\right.\right.$$

$$0.3\left(\cot\chi - \cot\chi\cos\frac{w\tan\chi}{b} - \frac{w}{b}\sin\frac{w\tan\chi}{b}\right)\right]\right]\right\}, \text{ where upper and lower signs correspond to } \odot\otimes \text{ and } \otimes\odot,$$

respectively, and

$$\sigma = 4\sqrt{A_{ex}K_0} + K_0\Delta\sin(\phi-\chi) - \pi\Delta M_s H_p\cos(\phi-\phi_H) - \pi\Delta M_s H_{DM}\cos(\phi-\chi) .$$

Note that many terms are much smaller than the dominant terms since $b, w \gg \Delta$, which leads to the following eqs. of motion:

$$(1+\alpha^2)\dot{q} \approx \mp\frac{\gamma\Delta}{M_s}K_0\sin 2(\phi-\chi)\sec\chi \pm \frac{\pi\gamma\Delta}{2}\sec\chi\left[H_p\sin(\phi-\phi_H) + \right.$$

$$H_{DMI}\sin(\phi-\chi)\right] \mp \frac{\pi}{2}\alpha\gamma H_{SH}\Delta\cos\phi\sec\chi - \frac{\pi\gamma A_{ex}}{bM_s}\cos\phi,$$

$$(1+\alpha^2)\dot{\phi} \approx \frac{\alpha\gamma}{M_s}K_0\sin 2(\phi-\chi) - \frac{\alpha\pi\gamma}{2}\left[H_p\sin(\phi-\phi_H) + H_{DMI}\sin(\phi-\chi)\right] -$$

$$\frac{\pi}{2}\gamma H_{SH}\cos\phi \pm \frac{\alpha\pi\gamma A_{ex}}{bM_s\Delta}\cos\phi\cos\chi,$$

$$\frac{\pi^2\alpha}{6\gamma}\left[\left(\frac{w}{\pi\Delta}\right)^2\sec^2\chi + \tan^2\chi\right]\dot{\chi} \approx -\frac{\sigma}{M_s\Delta}\tan\chi + \pi H_{DM}\sin(\phi-\chi) - H_k\sin 2(\phi-$$

$$\chi) \mp \frac{4A_{ex}}{wM_s\Delta}\cos\phi\cos\frac{q}{b}\left(\frac{b}{\Delta}\sin 2\chi\sin\frac{\pi\Delta\sec\chi}{2b} - \pi\sin\chi\cos\frac{\pi\Delta\sec\chi}{2b}\right)\left[0.4\cot\chi\left(1-\right.\right.$$

$$\cos\frac{w\tan\chi}{2b}\right) + \left(1-\frac{0.2w}{b}\right)\sin\frac{w\tan\chi}{2b}\right] \mp \frac{8bA_{ex}}{wM_s\Delta^2}\cos\phi\cos\frac{q}{b}\sin\frac{\pi\Delta\sec\chi}{2b}\left\{0.4\cot\chi\left[\cot\chi\left(1-\right.\right.\right.$$

$$\cos\frac{\pi\Delta\sec\chi}{2b}\right) - \frac{w}{2b}\sin\frac{\pi\Delta\sec\chi}{2b}\right] - \left(1-\frac{0.2w}{b}\right)\frac{w}{2b}\cos\frac{\pi\Delta\sec\chi}{2b}\right\}.$$

The most important term that is related to the torsion torque is $-\frac{\pi\gamma A_{ex}}{bM_s}\cos\phi$ , which corresponds to the mechanism of the torsion induced effect that is shown in Fig. 4.

**Claims**

1. A method for manipulating domain walls, DWs, in a magnetic ribbon, comprising the steps of

   a. providing a planar magnetic ribbon with a torsion angle of 0°,
   b. nucleating a DW in the ribbon by an electric field or current pulses or a combination of both, and
   c. applying current pulses to move the DW along/over the ribbon,

   **characterized in that** the movement of the DW is manipulated by imposing a curvilinear 3D structure upon at least one region of the magnetic ribbon, which then becomes a twisted region, such that the at least one twisted region has

   - a length of 5nm-1000$\mu$m, preferably 10nm-500$\mu$m, more preferred 20nm-50$\mu$m,
   - a width of 5nm-20$\mu$m, preferably 5nm-10$\mu$m, more preferred 5nm-5$\mu$m,
   - a thickness of 0.1-20nm, preferably 0.1-10nm, more preferred 0.5-5nm, and
   - an absolute torsion angle over the total length of 1-70°, preferably 5-55°, more preferred 10-45°.

2. The method of claim 1, wherein the DW is nucleated by a combination of an electric field and current pulses.

3. The method of claim 1 or 2, wherein two or more twisted regions are imposed over the total length of the magnetic ribbon, preferably two or three twisted regions.

4. The method of claim 1 or 2, wherein the at least one twisted region has a clockwise or anti-clockwise torsion.

5. The method of claim 3, wherein the two or more twisted regions have subsequent clockwise or subsequent anti-clockwise torsions, or alternating clockwise and anti-clockwise torsions or any combination thereof.

6. The method of claim 1, wherein manipulation of the DW comprises the change of the magnetic properties of the DW moving over/along the ribbon particularly the change of the dynamic magnetic properties such as driving torque, DW velocity, threshold current, DW tilting, tuning of the shift between two DWs, nucleation of a DW and precise stepwise motion of a DW.

7. A curvilinear 3D magnetic ribbon, which extends between two ends and which has at least one twisted region between its two ends wherein the twisted region has

   - a length of 5nm-1000$\mu$m, preferably 10nm-500$\mu$m, more preferred 20nm-50$\mu$m,
   - a width of 5nm-20$\mu$m, preferably 5nm-10$\mu$m, more preferred 5nm-5$\mu$m,
   - a thickness of 0.1-20nm, preferably 0.1-10nm, more preferred 0.5-5nm, and
   - an absolute torsion angle over the total length of 1-70°, preferably 5-55°, more preferred 10-45°.

8. The ribbon of claim 7, having two or more twisted regions over the total length of the magnetic ribbon, preferably two or three twisted regions.

9. The ribbon of claim 7 or 8, wherein the at least one twisted region has a clockwise or anti-clockwise torsion.

10. The ribbon of claim 8, wherein the two or more twisted regions have subsequent clockwise or subsequent anti-clockwise torsions, or alternating clockwise and anti-clockwise torsions or any combination thereof.

11. The use of the ribbon according to one of claims 7-10 for the precise stepwise motion of DWs or for the implementation of a neuromorphic device, a DW diode, a DW filter, a DW multiplexer, a device that tunes the shift between two DWs or a device that selectively nucleates DWs of a specific type by current.

**Patentansprüche**

1. Verfahren zum Manipulieren von Domänenwänden, DWs, in einem Magnetband, umfassend die folgenden Schritte:

   a. Bereitstellen eines planaren Magnetbands mit einem Torsionswinkel von 0°,
   b. Nukleieren eines DW in dem Band durch ein elektrisches Feld oder Stromimpulse oder eine Kombination von beiden, und

c. Anlegen von Stromimpulsen, um die DW entlang/über das Band zu bewegen,

**dadurch gekennzeichnet, dass** die Bewegung des DW durch Aufprägen einer krummlinigen 3D-Struktur auf mindestens einen Bereich des Magnetbands, der dann zu einem verdrehten Bereich wird, so manipuliert wird, dass der mindestens eine verdrehte Bereich Folgendes aufweist:

- eine Länge von 5nm-1000$\mu$m, vorzugsweise 10nm-500$\mu$m, bevorzugter 20nm-50$\mu$m,
- eine Breite von 5nm-20$\mu$m, vorzugsweise 5nm-10$\mu$m, bevorzugter 5nm-5$\mu$m,
- eine Dicke von 0,1-20nm, vorzugsweise 0,1-10nm, bevorzugter 0,5-5nm, und
- einen absoluten Torsionswinkel über die Gesamtlänge von 1-70°, vorzugsweise 5-55°, bevorzugter 10-45°.

2. Verfahren nach Anspruch 1, wobei die DW durch eine Kombination aus einem elektrischen Feld und Stromimpulsen nukleiert wird.

3. Verfahren nach Anspruch 1 oder 2, wobei zwei oder mehr verdrehte Bereiche über die Gesamtlänge des Magnetbandes aufgebracht werden, vorzugsweise zwei oder drei verdrehte Bereiche.

4. Verfahren nach Anspruch 1 oder 2, wobei der mindestens eine verdrehte Bereich eine Verdrehung im Uhrzeigersinn oder gegen den Uhrzeigersinn aufweist.

5. Verfahren nach Anspruch 3, wobei die zwei oder mehr verdrehten Bereiche nachfolgende Verdrehungen im Uhrzeigersinn oder gegen den Uhrzeigersinn oder alternierende Verdrehungen im Uhrzeigersinn und gegen den Uhrzeigersinn oder eine beliebige Kombination davon aufweisen.

6. Verfahren nach Anspruch 1, wobei die Manipulation der DW die Änderung der magnetischen Eigenschaften der DW umfasst, die sich über/entlang des Bandes bewegt, insbesondere die Änderung der dynamischen magnetischen Eigenschaften, wie etwa Antriebsmoment, DW-Geschwindigkeit, Schwellenstrom, DW-Kippen, Abstimmen der Verschiebung zwischen zwei DWs, Nukleierung einer DW und präzise schrittweise Bewegung einer DW.

7. Krummliniges 3D-Magnetband, das sich zwischen zwei Enden erstreckt und zwischen seinen beiden Enden mindestens einen verdrehten Bereich aufweist, wobei der verdrehte Bereich Folgendes aufweist:

- eine Länge von 5nm-1000$\mu$m, vorzugsweise 10nm-500$\mu$m, bevorzugter 20nm-50$\mu$m,
- eine Breite von 5nm-20$\mu$m, vorzugsweise 5nm-10$\mu$m, bevorzugter 5nm-5$\mu$m,
- eine Dicke von 0,1-20nm, vorzugsweise 0,1-10nm, bevorzugter 0,5-5nm, und
- einen absoluten Torsionswinkel über die Gesamtlänge von 1-70°, vorzugsweise 5-55°, bevorzugter 10-45°.

8. Band nach Anspruch 7 mit zwei oder mehr verdrehten Bereichen über die Gesamtlänge des Magnetbandes, vorzugsweise zwei oder drei verdrehten Bereichen.

9. Band nach Anspruch 7 oder 8, wobei der mindestens eine verdrehte Bereich eine im Uhrzeigersinn oder gegen den Uhrzeigersinn gerichtete Verdrehung aufweist.

10. Band nach Anspruch 8, wobei die zwei oder mehr verdrehten Bereiche nachfolgende Verdrehungen im Uhrzeigersinn oder gegen den Uhrzeigersinn oder alternierende Verdrehungen im Uhrzeigersinn und gegen den Uhrzeigersinn oder eine beliebige Kombination davon aufweisen.

11. Verwendung des Bands nach einem der Ansprüche 7-10 zur präzisen schrittweisen Bewegung von DWs oder zur Implementierung einer neuromorphen Vorrichtung, einer DW-Diode, eines DW-Filters, eines DW-Multiplexers, einer Vorrichtung, die die Verschiebung zwischen zwei DWs abstimmt, oder einer Vorrichtung, die DWs eines bestimmten Typs gezielt durch Strom nukleiert.

**Revendications**

1. Procédé de manipulation de parois de domaine, DW, dans un ruban magnétique, comprenant les étapes suivantes :

a. la fourniture d'un ruban magnétique plan avec un angle de torsion de 0°,

b. la nucléation d'une DW dans le ruban par un champ électrique ou des impulsions de courant ou une combinaison des deux, et

c. l'application d'impulsions de courant pour déplacer la DW le long du/sur le ruban,

**caractérisé en ce que** le déplacement de la DW est manipulé en imposant une structure 3D curviligne à au moins une région du ruban magnétique, qui devient alors une région torsadée, de telle sorte que la ou les régions torsadées présentent

- une longueur de 5 nm à 1000 $\mu$m, préférablement de 10 nm à 500 $\mu$m, plus préférablement de 20 nm à 50 $\mu$m,
- une largeur de 5 nm à 20 $\mu$m, préférablement de 5 nm à 10 $\mu$m, plus préférablement de 5 nm à 5 $\mu$m,
- une épaisseur de 0,1 à 20 nm, préférablement de 0,1 à 10 nm, plus préférablement de 0,5 à 5 nm, et
- un angle de torsion absolu sur la longueur totale de 1 à 70°, de préférence de 5 à 55°, plus préférablement de 10 à 45°.

2. Procédé selon la revendication 1, dans lequel la DW est nucléée par une combinaison d'un champ électrique et d'impulsions de courant.

3. Procédé selon la revendication 1 ou 2, dans lequel deux régions torsadées ou plus sont imposées sur la longueur totale du ruban magnétique, de préférence deux ou trois régions torsadées.

4. Procédé selon la revendication 1 ou 2, dans lequel la ou les régions torsadées présentent une torsion dans le sens horaire ou anti-horaire.

5. Procédé selon la revendication 3, dans lequel les deux régions torsadées ou plus ont des torsions successives dans le sens horaire ou successives dans le sens anti-horaire, ou des torsions alternées dans le sens horaire et anti-horaire ou toute combinaison de celles-ci.

6. Procédé selon la revendication 1, dans lequel la manipulation de la DW comprend le changement des propriétés magnétiques de la DW se déplaçant sur/le long du ruban, en particulier le changement des propriétés magnétiques dynamiques telles que le couple d'entraînement, la vitesse de la DW, le courant de seuil, l'inclinaison de la DW, le réglage du décalage entre deux DW, la nucléation d'une DW et le mouvement progressif précis d'une DW.

7. Ruban magnétique 3D curviligne, qui s'étend entre deux extrémités et qui présente au moins une région torsadée entre ses deux extrémités, la région torsadée présentant

- une longueur de 5 nm à 1000 $\mu$m, préférablement de 10 nm à 500 $\mu$m, plus préférablement de 20 nm à 50 $\mu$m,
- une largeur de 5 nm à 20 $\mu$m, préférablement de 5 nm à 10 $\mu$m, plus préférablement de 5 nm à 5 $\mu$m,
- une épaisseur de 0,1 à 20 nm, préférablement de 0,1 à 10 nm, plus préférablement de 0,5 à 5 nm, et
- un angle de torsion absolu sur la longueur totale de 1 à 70°, de préférence de 5 à 55°, plus préférablement de 10 à 45°.

8. Ruban selon la revendication 7, ayant deux régions torsadées ou plus sur la longueur totale du ruban magnétique, de préférence deux ou trois régions torsadées.

9. Ruban selon la revendication 7 ou 8, dans lequel la ou les régions torsadées présentent une torsion dans le sens horaire ou anti-horaire.

10. Ruban selon la revendication 8, dans lequel les deux régions torsadées ou plus ont des torsions successives dans le sens horaire ou successives dans le sens anti-horaire, ou des torsions alternées dans le sens horaire et anti-horaire ou toute combinaison de celles-ci.

11. Utilisation du ruban selon l'une des revendications 7 à 10 pour le déplacement progressif précis de DWS ou pour la mise en œuvre d'un dispositif neuromorphe, d'une diode DW, d'un filtre DW, d'un multiplexeur DW, d'un dispositif qui règle le décalage entre deux DW ou d'un dispositif nucléant sélectivement des DW d'un type spécifique par courant.

Figure 1

Figure 2

EP 4 465 803 B1

Figure 3

Figure 4

18

Figure 5

Figure 6

Figure 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6834005 B

**Non-patent literature cited in the description**

- **LUO, Z.** ; **HRABEC, A.** ; **DAO, T.P. et al.** Current-driven magnetic domain-wall logic.. *Nature*, 2020, vol. 579, 214-218
- **GU K et al.** Three-dimensional racetrack memory devices designed from freestanding magnetic heterostructures. *NATURE NANOTECHNOLOGY*, 22 September 2022, vol. 17 (10), 1065-1071
- **ZHUKOV A P**. The remagnetization process of bistable amorphous alloys. *MATERIALS AND DESIGN*, 01 January 1993, vol. 14 (5), 299-306
- **KAMER O et al.** Direct current hysteresis loops of Fe-based amorphous ribbons under stress and torsion. *JOURNAL OF PHYSICS D: APPLIED PHYSICS*, 21 September 1999, vol. 32 (24), 3151-3156
- **PYLYPOVSKYI O V et al.** Coupling of Chiralities in Spin and Physical Spaces: The Möbius Ring as a Case Study. *PHYSICAL REVIEW LETTERS*, 15 May 2015, vol. 114 (19), 197204
- **CORODEANU S et al.** Field and Current Controlled Domain Wall Propagation in Twisted Glass-Coated Magnetic Microwires. *SCIENTIFIC REPORTS*, 10 April 2019, vol. 9, 5868
- **HUNT, M. et al.** Harnessing Multi-Photon Absorption to Produce Three-Dimensional Magnetic Structures at the Nanoscale.. *Materials*, 2020, vol. 13, 761
- **HARINARAYANA, V.** ; **SHIN, Y. C.** Two-photon lithography for three-dimensional fabrication in micro/nanoscale regime: A comprehensive review.. *Optics & Laser Technology*, 2021, vol. 142, 107180
- **NISHIGUCHI, A. et al.** 4D Printing of a Light-Driven Soft Actuator with Programmed Printing Density.. *ACS Applied Materials & Interfaces*, 2020, vol. 12, 10
- **ZAMIR, S. W. et al.** Multi-Stage Progressive Image Restoration.. *arXiv:2102.02808*, 2021